# EUROPEAN PATENT APPLICATION

(11) **EP 3 082 258 A1**
(43) Date of publication of application: **19.10.2016**
(21) Application number: 14794083.7
(22) Date of filing: 10.06.2014
(51) Int. Cl.: H03F 3/189

(54) **RADIO-FREQUENCY POWER AMPLIFIER POWER SUPPLY METHOD AND DEVICE**

(30) Priority: 13.12.2013 CN 201310687468
(71) Applicant: ZTE Corporation, Shenzhen, Guangdong 518057 (CN)
(72) Inventor: CHEN, Huazhang, Shenzhen Guangdong 518057 (CN); WANG, Gang, Shenzhen Guangdong 518057 (CN); AN, Jinyuan, Shenzhen Guangdong 518057 (CN)
(74) Representative: Quinterno, Giuseppe
(86) International application number: PCT/CN2014/079632
(87) International publication number: WO 2014/180437

(57) **Abstract**

A power supply method and device for a radio-frequency power amplifier are provided, which relates to the technical field of Printed Circuit Boards (PCBs). The method includes: drains or collectors, configured to output amplified signals, of each of multiple radio-frequency power amplifier tubes in a radio-frequency power amplifier unit are directly connected through a first microstrip line; the first microstrip line is connected to a second microstrip line configured for radio-frequency output through a blocking capacitor; a grid or base voltage is correspondingly applied to grids or bases of each of the multiple radio-frequency power amplifier tubes respectively; and a drain or collector voltage is correspondingly applied to the drain or collector of one radio-frequency power amplifier tube in the multiple radio-frequency power amplifier tubes, and then the drain or collector voltage is correspondingly applied to the drains or collectors of the other radio-frequency power amplifier tubes in the multiple radio-frequency power amplifier tubes through the first microstrip line respectively. The design is unique in circuit, flexible layout of a PCB may be implemented, and an increasingly sharp conflict between miniaturization and high power may be resolved.

## Description

### Technical Field

The present invention relates to the technical field of Printed Circuit Boards (PCBs), and in particular to a power supply method and device for a radio-frequency power amplifier.

### Background

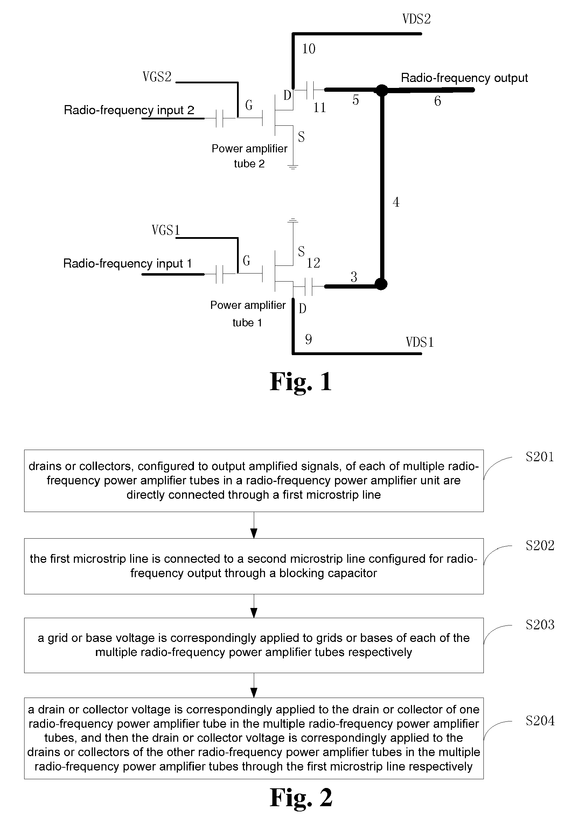

Along with fiercer competition of base station products, customers put forward many new requirements, such as further increase of a peak-to-average ratio, further improvement of set-top power and miniaturization of a Radio Remote Unit (RRU). Due to limits of a power level of a single power amplifier tube, it is necessary to synthesize more power amplifier tubes on the same PCB. A diagram of conventional power supply to power amplifier tubes is shown in Fig. 1, drain voltage VDS1 supplies power to a power amplifier tube 1 through a drain power supply arm 9, and simultaneously, drain voltage VDS2 supplies power to a power amplifier tube 2 through a drain power supply arm 10. Due to existence of a block capacitor 12, the drain voltage VDS1 may not pass through a microstrip line 3 when supplying power to the power amplifier tube 1, and meanwhile, due to existence of a blocking capacitor 11, the drain voltage VDS2 may not pass through a microstrip line 5 when supplying power to the power amplifier tube 2.

At present, there are two power supply solutions in a conventional art: 1: power supply for each power amplifier tube is shown in Fig. 1, as such each power amplifier tube requires a power supply terminal, and a power amplifier board power supply may have many external interfaces; and 2: a technology of erecting a power supply bridge through a fly wire in the air is also adopted to supply power to power amplifier tubes in the conventional art, then the power amplifier board power supply has only one external interface, but such a technology may cause a great height of a power amplifier board and influence on resonance in a cavity of a power amplifier.

### Summary

The embodiment of the present invention provides a power supply method and device for a radio-frequency power amplifier, which solve the problems of incapability of a drain voltage in passing through a microstrip line to supply power to another power amplifier tube and waste of a circuit board space in the conventional art.

According to one aspect of the present invention, a power supply method for a radio-frequency power amplifier is provided, which may include the following steps that:
drains or collectors, configured to output amplified signals, of each of multiple radio-frequency power amplifier tubes in a radio-frequency power amplifier unit are directly connected through a first microstrip line;
the first microstrip line is connected to a second microstrip line configured for radio-frequency output through a blocking capacitor;
a grid or base voltage is correspondingly applied to grids or bases of each of the multiple radio-frequency power amplifier tubes respectively; and
a drain or collector voltage is correspondingly applied to the drain or collector of one radio-frequency power amplifier tube in the multiple radio-frequency power amplifier tubes, and then the drain or collector voltage is correspondingly applied to the drains or collectors of the other radio-frequency power amplifier tubes in the multiple radio-frequency power amplifier tubes through the first microstrip line respectively.

Preferably, the first microstrip line may consist of multiple microstrip lines, and the second microstrip line may consist of one microstrip line.

Preferably, the multiple microstrip lines may include:
multiple connecting microstrip lines connected with the drains or collectors of the multiple radio-frequency power amplifier tubes respectively; and
a common microstrip line connected between the multiple connecting microstrip lines and the blocking capacitor.

Preferably, the grid or base voltage may be correspondingly applied to the grids or bases of each of the multiple radio-frequency power amplifier tubes in the radio-frequency power amplifier unit through a grid power supply arm or a base power supply arm respectively.

Preferably, the drain or collector voltage may be correspondingly applied to the drain or collector of one radio-frequency power amplifier tube in the multiple radio-frequency power amplifier tubes through a drain power supply arm or a collector power supply arm, and then the drain or collector voltage may be correspondingly applied to the drains or collectors of the other radio-frequency power amplifier tubes in the multiple radio-frequency power amplifier tubes through the multiple microstrip lines.

According to the other aspect of the present invention, a power supply device for a radio-frequency power amplifier is provided, which may include:
a connecting module, configured to connect drains or collectors, configured to output amplified signals, of each of multiple radio-frequency power amplifier tubes in a radio-frequency power amplifier unit through a first microstrip line, and connect the first microstrip line to a second microstrip line configured for radio-frequency output through a blocking capacitor; and
a power supply module, configured to correspondingly apply a grid or base voltage to grids or bases of each of the multiple radio-frequency power amplifier tubes respectively, correspondingly apply a drain or collector voltage to the drain or collector of one radio-frequency power amplifier tube in the multiple radio-frequency power amplifier tubes, and then correspondingly apply the drain or collector voltage to the drains or collectors of the other radio-frequency power amplifier tubes in the multiple radio-frequency power amplifier tubes through the first microstrip line respectively.

Preferably, the connecting module may include a first microstrip line unit.

Preferably, the first microstrip line unit may include:
a connecting microstrip line subunit, configured to include multiple microstrip lines connected with the drains or collectors of the multiple radio-frequency power amplifier tubes respectively; and
a common microstrip line subunit, configured to include a common microstrip line connected between the multiple connecting microstrip lines and the blocking capacitor.

Preferably, the power supply module may include:
a grid or base power supply unit, configured to correspondingly apply the grid or base voltage to the grids or bases of each of the multiple radio-frequency power amplifier tubes in the radio-frequency power amplifier unit through a grid power supply arm or a base power supply arm respectively.

Preferably, the power supply module may further include:
a drain or collector power supply unit, configured to correspondingly apply the drain or collector voltage to the drain or collector of one radio-frequency power amplifier tube in the multiple radio-frequency power amplifier tubes through a drain power supply arm or a collector power supply arm, and then correspondingly apply the drain or collector voltage to the drains or collectors of the other radio-frequency power amplifier tubes in the multiple radio-frequency power amplifier tubes through the multiple microstrip lines.

Compared with the conventional art, the embodiment of the present invention has the following beneficial effects:
in the embodiment of the present invention, a radio-frequency wire and direct current wire shared design is adopted, and the method and the device are applied to an environment with more than or equal to two power amplifier tubes, so that more space is saved, and layout of a power amplifier tube is more facilitated.

### Brief Description of the Drawings

Fig. 1 is a circuit diagram of conventional power supply to power amplifier tubes according to the conventional art;
Fig. 2 is a flowchart of a power supply method for a radio-frequency power amplifier according to an embodiment of the present invention;
Fig. 3 is a diagram of a power supply device for a radio-frequency power amplifier according to an embodiment of the present invention;
Fig. 4 is a circuit diagram of a shared design structure for two power amplifier tubes according to an embodiment of the present invention; and
Fig. 5 is a circuit diagram of a shared design structure for N power amplifier tubes according to an embodiment of the present invention.

### Detailed Description of the Embodiments

A preferred embodiment of the present invention will be described below with reference to the drawings in detail, and it should be understood that the preferred embodiment described below is only adopted to describe and explain the present invention and not intended to limit the present invention.

In the present invention, radio-frequency power amplifier tubes work at static working points at first, that is, power is supplied to grids and drains of the power amplifier tubes to enable them to work at the static working points through a power supply arm respectively, and then small radio-frequency signals are input from the grids of the power amplifier tubes, and are output from the drains of the power amplifier tubes after being amplified. In the present invention, a blocking capacitor is shifted to an output end, thereby implementing multiplexing of a radio-frequency energy wire and a direct current wire.

Fig. 2 is a flowchart of a power supply method for a radio-frequency power amplifier according to an embodiment of the present invention, and as shown in Fig. 2, the method includes the following steps:
Step 201: drains or collectors, configured to output amplified signals, of each of multiple radio-frequency power amplifier tubes in a radio-frequency power amplifier unit are directly connected through a first microstrip line;
Step 202: the first microstrip line is connected to a second microstrip line configured for radio-frequency output through a blocking capacitor;
Step 203: a grid or base voltage is correspondingly applied to grids or bases of each of the multiple radio-frequency power amplifier tubes respectively; and
Step 204: a drain or collector voltage is correspondingly applied to the drain or collector of one radio-frequency power amplifier tube in the multiple radio-frequency power amplifier tubes, and then the drain or collector voltage is correspondingly applied to the drains or collectors of the other radio-frequency power amplifier tubes in the multiple radio-frequency power amplifier tubes through the first microstrip line respectively.
Wherein, the first microstrip line consists of multiple microstrip lines, and the second microstrip line consists of one microstrip line.

Specifically, the multiple microstrip lines include: multiple connecting microstrip lines connected with the drains or collectors of the multiple radio-frequency power amplifier tubes respectively; and a common microstrip line connected between the multiple connecting microstrip lines and the blocking capacitor.

In the present invention, the grid or base voltage is correspondingly applied to the grids or bases of each of the multiple radio-frequency power amplifier tubes in the radio-frequency power amplifier unit through a grid power supply arm or a base power supply arm respectively; and the drain or collector voltage is correspondingly applied to the drain or collector of one radio-frequency power amplifier tube in the multiple radio-frequency power amplifier tubes through a drain power supply arm or a collector power supply arm, and then the drain or collector voltage is correspondingly applied to the drains or collectors of the other radio-frequency power amplifier tubes in the multiple radio-frequency power amplifier tubes through the multiple microstrip lines.

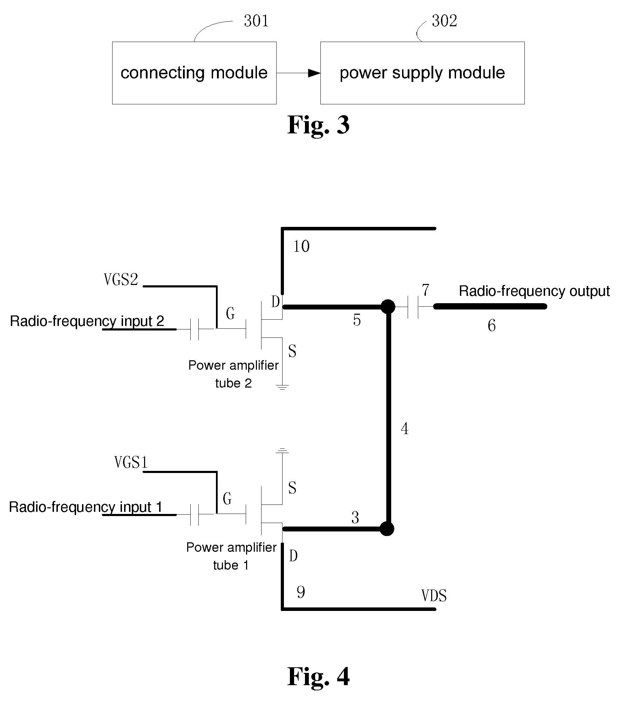

Fig. 3 is a diagram of a power supply device for a radio-frequency power amplifier according to an embodiment of the present invention, and as shown in Fig. 3, the device includes: a connecting module 301, configured to connect drains or collectors, configured to output amplified signals, of each of multiple radio-frequency power amplifier tubes in a radio-frequency power amplifier unit through a first microstrip line, and connect the first microstrip line to a second microstrip line configured for radio-frequency output through a blocking capacitor; and a power supply module 302, configured to correspondingly apply a grid or base voltage to grids or bases of each of the multiple radio-frequency power amplifier tubes respectively, correspondingly apply a drain or collector voltage to the drain or collector of one radio-frequency power amplifier tube in the multiple radio-frequency power amplifier tubes, and then correspondingly apply the drain or collector voltage to the drains or collectors of the other radio-frequency power amplifier tubes in the multiple radio-frequency power amplifier tubes through the first microstrip line respectively.

The connecting module of the present invention includes a first microstrip line unit, wherein the first microstrip line unit includes: a connecting microstrip line subunit, configured to include multiple microstrip lines connected with the drains or collectors of the multiple radio-frequency power amplifier tubes respectively; and a common microstrip line subunit, configured to include a common microstrip line connected between the multiple connecting microstrip lines and the blocking capacitor.

The power supply module 302 of the present invention includes: a grid or base power supply unit, configured to correspondingly apply the grid or base voltage to the grids or bases of each of the multiple radio-frequency power amplifier tubes in the radio-frequency power amplifier unit through a grid power supply arm or a base power supply arm respectively; and a drain or collector power supply unit, configured to correspondingly apply the drain or collector voltage to the drain or collector of one radio-frequency power amplifier tube in the multiple radio-frequency power amplifier tubes through a drain power supply arm or a collector power supply arm, and then correspondingly apply the drain or collector voltage to the drains or collectors of the other radio-frequency power amplifier tubes in the multiple radio-frequency power amplifier tubes through the multiple microstrip lines.

According to the present invention, the grid voltage VGS and the drain voltage VDS may also be the base voltage and the collector voltage, and the power amplifier tubes are not limited to Lateral Double-diffused Metal-Oxide Semiconductor (LDMOS) tubes.

The present invention is applicable to a place with more than or equal to 2 power amplifier tubes.

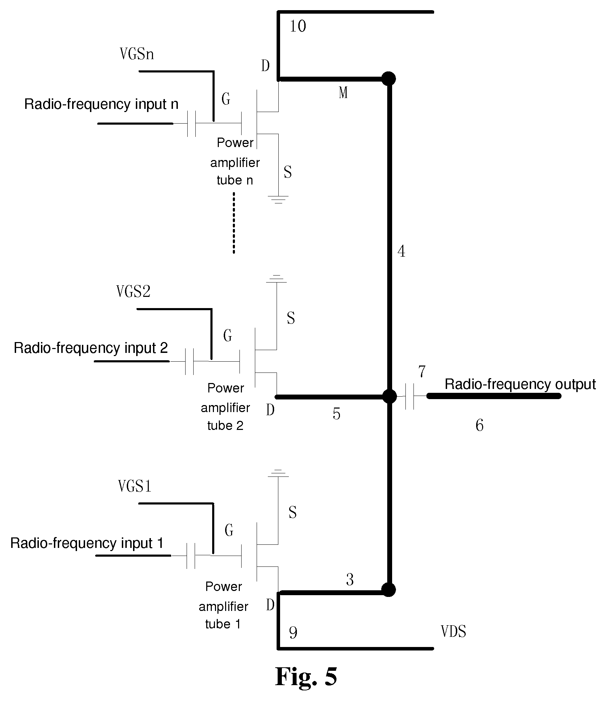

Contents of the present invention will be specifically described below with specific embodiments with two power amplifier tubes in Fig. 4 and N power amplifier tubes in Fig. 5.

Fig. 4 is a circuit diagram of a shared design structure for two power amplifier tubes according to an embodiment of the present invention. As shown in Fig. 4, grid voltage VGS1 supplies power to a power amplifier tube 1, drain voltage VDS supplies power to the power amplifier tube 1 through a drain power supply arm 9, then direct current supplies power to a power amplifier tube 2 through a connecting microstrip line 3, common microstrip line 4 and connecting microstrip line 5 of the first microstrip line, and vice versa, that is, grid voltage VGS2 supplies power to the power amplifier tube 2, and drain voltage VDS may supply power to the power amplifier tube 2 at first through a drain power supply arm 10, and then supplies power to the power amplifier tube 1 through the connecting microstrip line 5, common microstrip line 4 and connecting microstrip line 3 of the first microstrip line. Meanwhile, radio-frequency input 1 passes through the connecting microstrip line 3 and the common microstrip line 4 after being amplified by the power amplifier tube 1; radio-frequency input 2 passes through the connecting microstrip line 5 after being amplified by the power amplifier tube 2; and then the two paths of radio-frequency energy are combined at the blocking capacitor 7 to obtain radio-frequency output passing through the second microstrip line 6 to implement direct current wire and radio-frequency wire sharing through the connecting microstrip line 3, common microstrip line 4 and connecting microstrip line 5 of the first microstrip line.

Fig. 5 is a circuit diagram of a shared design structure for N power amplifier tubes according to an embodiment of the present invention. As shown in Fig. 5, grid voltage VGS1 supplies power to a power amplifier tube 1, drain voltage VDS supplies power to the power amplifier tube 1 through a drain power supply arm 9, then direct current supplies power to power amplifier tubes 2...N through a connecting microstrip line 3, common microstrip line 4 and multiple connecting microstrip lines 5...M of the first microstrip line, and vice versa, that is, grid voltage VGSn supplies power to the power amplifier tube N, and drain voltage VDS may supply power to the power amplifier tube N at first through a drain power supply arm 10, and then supplies power to the power amplifier tube 1 through the connecting microstrip line M, common microstrip line 4 and connecting microstrip lines M-1...3 of the first microstrip line. Meanwhile, radio-frequency input 1 passes through the connecting microstrip line 3 and the common microstrip line 4 after being amplified by the power amplifier tube 1; ...; radio-frequency input N passes through the connecting microstrip line M and the common microstrip line 4 after being amplified by the power amplifier tube N; and then the two paths of radio-frequency energy are combined at the blocking capacitor 7 to obtain radio-frequency output passing through the second microstrip line 6 to implement direct current wire and radio-frequency wire sharing through the connecting microstrip line 3, common microstrip line 4 and multiple connecting microstrip lines 5...M of the first microstrip line.

From the above, the present invention has the following beneficial effects:
In layout of a PCB, including input matching and output matching, drain feed PCB areas of the power amplifier tubes are 1/6 of PCB areas of the whole power amplifier tubes, and compared with a conventional power supply manner, the technology has the advantages that the drain feed PCB areas may be reduced by 1/12 in case of two power amplifier tubes and the drain feed PCB areas may be reduced by 1/9 in case of three power amplifier tubes. Therefore, adoption of the direct current wire and radio-frequency wire sharing manner of the present invention may achieve higher flexibility in layout, and an increasingly sharp conflict between miniaturization and high power is resolved.

The above is only the detailed description of the present invention and not intended to limit the present invention, and those skilled in the art may make various modifications according to the principle of the present invention. Therefore, all the modifications made according to the principle of the present invention shall fall within the scope of protection of the present invention.

## Claims

1. A power supply method for a radio-frequency power amplifier, comprising:
directly connecting drains or collectors, configured to output amplified signals, of each of multiple radio-frequency power amplifier tubes in a radio-frequency power amplifier unit through a first microstrip line;
connecting the first microstrip line to a second microstrip line used for radio-frequency output through a blocking capacitor;
correspondingly applying a grid or base voltage to grids or bases of each of the multiple radio-frequency power amplifier tubes respectively; and
correspondingly applying a drain or collector voltage to the drain or collector of one radio-frequency power amplifier tube in the multiple radio-frequency power amplifier tubes, and then correspondingly applying the drain or collector voltage to the drains or collectors of the other radio-frequency power amplifier tubes in the multiple radio-frequency power amplifier tubes through the first microstrip line respectively.

2. The method according to claim 1, wherein the first microstrip line consists of multiple microstrip lines, and the second microstrip line consists of one microstrip line.

3. The method according to claim 2, wherein the multiple microstrip lines comprise:
multiple connecting microstrip lines connected with the drains or collectors of the multiple radio-frequency power amplifier tubes respectively; and
a common microstrip line connected between the multiple connecting microstrip lines and the blocking capacitor.

4. The method according to any one of claims 1 to 3, wherein the grid or base voltage is correspondingly applied to the grids or bases of each of the multiple radio-frequency power amplifier tubes in the radio-frequency power amplifier unit through a grid power supply arm or a base power supply arm respectively.

5. The method according to claim 4, wherein the drain or collector voltage is correspondingly applied to the drain or collector of one radio-frequency power amplifier tube in the multiple radio-frequency power amplifier tubes through a drain power supply arm or a collector power supply arm, and then the drain or collector voltage is correspondingly applied to the drains or collectors of the other radio-frequency power amplifier tubes in the multiple radio-frequency power amplifier tubes through the multiple microstrip lines.

6. A power supply device for a radio-frequency power amplifier, comprising:
a connecting module, configured to connect drains or collectors, configured to output amplified signals, of each of multiple radio-frequency power amplifier tubes in a radio-frequency power amplifier unit through a first microstrip line, and connect the first microstrip line to a second microstrip line configured for radio-frequency output through a blocking capacitor; and
a power supply module, configured to correspondingly apply a grid or base voltage to grids or bases of each of the multiple radio-frequency power amplifier tubes respectively, correspondingly apply a drain or collector voltage to the drain or collector of one radio-frequency power amplifier tube in the multiple radio-frequency power amplifier tubes, and then correspondingly apply the drain or collector voltage to the drains or collectors of the other radio-frequency power amplifier tubes in the multiple radio-frequency power amplifier tubes through the first microstrip line respectively.

7. The device according to claim 6, wherein the connecting module comprises a first microstrip line unit.

8. The device according to claim 7, wherein the first microstrip line unit comprises:
a connecting microstrip line subunit, configured to comprise multiple microstrip lines connected with the drains or collectors of the multiple radio-frequency power amplifier tubes respectively; and
a common microstrip line subunit, configured to comprise a common microstrip line connected between the multiple connecting microstrip lines and the blocking capacitor.

9. The device according to claim 7, wherein the power supply module comprises:
a grid or base power supply unit, configured to correspondingly apply the grid or base voltage to the grids or bases of each of the multiple radio-frequency power amplifier tubes in the radio-frequency power amplifier unit through a grid power supply arm or a base power supply arm respectively.

10. The device according to claim 9, wherein the power supply module further comprises:
a drain or collector power supply unit, configured to correspondingly apply the drain or collector voltage to the drain or collector of one radio-frequency power amplifier tube in the multiple radio-frequency power amplifier tubes through a drain power supply arm or a collector power supply arm, and then correspondingly apply the drain or collector voltage to the drains or collectors of the other radio-frequency power amplifier tubes in the multiple radio-frequency power amplifier tubes through the multiple microstrip lines.
